# EUROPÄISCHE PATENTSCHRIFT

(11) **EP 4 062 725 B1**
(45) Veröffentlichungstag und Bekanntmachung des Hinweises auf die Patenterteilung: **01.01.2025**
(21) Anmeldenummer: 20804492.5
(22) Anmeldetag: 09.11.2020
(51) Int. Cl.: H05K 9/00

(54) **FLEXIBLES LAMINAT ZUR ABSCHIRMUNG ELEKTROMAGNETISCHER STRAHLUNG**
FLEXIBLE LAMINATE FOR SHIELDING ELECTROMAGNETIC RADIATION
STRATIFIÉ FLEXIBLE POUR LE BLINDAGE CONTRE LES RAYONNEMENTS ÉLECTROMAGNÉTIQUES

(30) Priorität: 21.11.2019 DE 102019131499
(43) Veröffentlichungstag der Anmeldung: 28.09.2022
(73) Patentinhaber: Carl Freudenberg KG, 69469 Weinheim (DE)
(72) Erfinder: SCHNEIDER, Ulrich, 64297 Darmstadt (DE); SENNE, Sarah, 64658 Fürth (DE); ZAPLATILEK, Michael, 69488 Birkenau (DE)
(86) Internationale Anmeldenummer: PCT/EP2020/081481
(87) Internationale Veröffentlichungsnummer: WO 2021/099163

(56) Entgegenhaltungen:
- DE-A1- 102012 206 549
- DE-A1- 102012 206 549
- DE-B4- 102012 206 549
- JP-A- 2010 140 875
- JP-A- 2010 140 875
- US-A1- 2013 285 846
- US-A1- 2013 285 846
- US-A1- 2014 360 771
- US-A1- 2014 360 771

## Beschreibung

### HINTERGRUND DER ERFINDUNG

Die vorliegende Erfindung betrifft ein flexibles Laminat zur Abschirmung elektromagnetischer Strahlung, ein Verfahren zur Herstellung eines gegenüber elektromagnetischer Strahlung abgeschirmten Bauteils, die nach diesem Verfahren erhaltenen Bauteile und die Verwendung des flexiblen Laminats zur Abschirmung elektromagnetischer Strahlen.

### STAND DER TECHNIK

Elektromagnetische Wellen weisen eine elektrische und eine magnetische Feldkomponente auf. Die von elektronischen Bauteilen, sei es von stromführenden oder solchen, die zur Stromspeicherung eingesetzt werden, abgestrahlten Wellen können zu einer gegenseitigen elektromagnetischen Beeinflussung (electromagnetic interference, EMI) führen. Durch die enormen Fortschritte in der Halbleitertechnik sind die elektronischen Bauteile zunehmend kleiner geworden, und ihre Dichte innerhalb von elektronischen Vorrichtungen hat deutlich zugenommen. Die zunehmende Komplexität elektronischer Systeme, z. B. in Bereichen wie der Elektromobilität, der Luft- und Raumfahrttechnik, der Medizintechnik oder der Unterhaltungselektronik, stellt eine hohe Herausforderung an die elektromagnetische Verträglichkeit der einzelnen Komponenten dar. So werden z. B. in Elektrofahrzeugen elektrische Antriebe mit hohen Leistungen auf engstem Raum integriert und durch elektronische Bauteile gesteuert. Zur Speicherung und Bereitstellung der elektrischen Energie werden in vielen Bereichen Li-Ionen-Batterien mit der zugehörigen Steuerelektronik eingesetzt. Es muss sichergestellt werden, das sich die einzelnen Bauteile keineswegs gegenseitig stören. Um eine elektromagnetische Verträglichkeit zu erreichen, ist es bekannt, elektromagnetische Beeinflussungen mit Hilfe von abschirmenden Gehäusen zu dämpfen. Der Begriff der elektromagnetischen Verträglichkeit (EMV) wird beispielsweise nach DIN VDE 0870 definiert als die Fähigkeit einer elektrischen Einrichtung, in ihrer Umgebung zufriedenstellend zu funktionieren, ohne diese Umgebung, zu der auch andere Einrichtungen gehören können, unzulässig zu beeinflussen. Damit muss die EMV zwei Bedingungen erfüllen, die Abschirmung der ausgesendeten Strahlung und die Störfestigkeit gegenüber anderer elektromagnetischer Strahlung. In vielen Ländern müssen die entsprechenden Geräte dabei gesetzlichen Vorschriften genügen. Die elektromagnetische Beeinflussung (EMI) ist nach DIN VDE 0870 die Einwirkung elektromagnetischer Wellen auf Stromkreise, Geräte, Systeme oder Lebewesen. Eine solche Einwirkung kann bei den beeinflussten Objekten zu hinnehmbaren, aber auch nicht hinnehmbaren Beeinträchtigungen, z. B. der Funktionalität von Geräten oder der Gefährdung von Personen, führen. In solchen Fällen sind entsprechende Schutzvorkehrungen zu treffen. Der für EMI-Abschirmung relevante Frequenzbereich liegt im Allgemeinen zwischen 100 Hz und 100 GHz, speziell von etwa 10 MHz bis 10 GHz.

Elektromagnetische Verträglichkeit der Bauteile sowie Energieeinsparung und Thermomanagement sind die Herausforderungen für eine erfolgreiche Elektromobilitätstechnologie. Der Einsatz von modernen bürstenlosen Elektromotoren sowie diverse Steuerungseinheiten erfordern die Bereitstellung elektrischer Leistung in Form von Wechsel- und Drehstrom. Dabei senden die elektronischen Komponenten unerwünschte magnetische, elektrische und elektromagnetische Schwingungen unterschiedlicher Frequenz aus, die zum einen eine Störquelle für andere Steuerungseinheiten sein kann, oder die Steuerungseinheit selbst wird durch die ausgesendeten Schwingungen der anderen Bauteile in ihrer Funktion gestört.

Es ist bekannt, elektronische Komponenten mit Gehäusen aus Metall, z. B. Aluminium, elektromagnetisch abzuschirmen, damit sich diese in ihrer Funktionsausübung nicht gegenseitig negativ beeinflussen. Der Einsatz von rein metallischen Abschirmungen ist aber mit verschiedenen Nachteilen verbunden, wie das hohe Materialgewicht und die aufwendige Herstellung durch Stanzen, Biegen und Aufbringen eines Korrosionsschutzes, was sehr kostenintensiv ist. Auch die konstruktive Gestaltungsfreiheit ist bei metallischen Werkstoffen sehr beschränkt. Abschirmungen aus Kunststoff lassen sich vielfach leichter als Metalle in die gewünschte Form bringen. Da die meisten Kunststoffe Isolatoren sind, kann diesen durch den Auftrag einer Oberflächenbeschichtung, z. B. durch Galvanisieren oder Gasphasenabscheidung (physical vapor deposition, PVD), die erforderliche Leitfähigkeit verliehen werden. Alternativ ist es bekannt, Schichtmaterialien einzusetzen, die wenigstens eine kunststoff- und/oder faserhaltige Schicht und wenigstens eine Aluminiumschicht umfassen. Nachteilig an diesen Schichtmaterialien ist, dass ihre Befähigung zur dreidimensionalen Verformung ohne mechanische Beschädigung, speziell Rissbildung, sehr eingeschränkt ist.

Zur elektromagnetischen Abschirmung von Bildschirmen ist es auch bekannt, einen transparenten Träger einzusetzen, der ein aufgedrucktes Gitter aus einem elektromagnetisch abschirmenden Material mit dünnen, weit auseinanderliegenden Gitterlinien aufweist. So beschreibt die EP 0998182 A2 (DE 69923142 T2) eine elektromagnetische Abschirmplatte, die als Frontplatte vor einem Bildschirm montiert werden kann, um elektromagnetische Strahlung abzuschirmen, die von der Vorderseite des Bildschirms austritt. Die elektromagnetische Abschirmung erfolgt durch ein leitfähiges Gitter, bei dem die einzelnen Linien ausreichend dünn ausgebildet sein und ausreichende Abstände aufweisen müssen, damit die Gitterlinien möglichst nicht sichtbar sind. Zur Erzeugung des Gittermusters wird beispielsweise eine Glasplatte mit einer leitfähigen Paste bedruckt.

Die DE 102005001063 A1 beschreibt ein Schichtmaterial zur Abschirmung von elektromagnetischen Wellen, speziell in Gebäuden. Das Schichtmaterial umfasst mindestens eine Faser-umfassende Schicht und mindestens eine Aluminiumschicht. Bei der Faser-umfassenden Schicht kann es sich um Gewebe, Gestricke, Gewirke, Gelege, Faserbündel und bevorzugt Faservliese handeln. Es ist beschrieben, dass sowohl die Aluminiumschicht als auch die Faser-umfassende Schicht mit einer Perforation versehen werden kann, damit Kleber und Bitumen besser in das Material eindringen und Gas entweichen kann. An anderer Stelle wird beschrieben, dass die Aluminiumschicht eine Dehnbarkeit in mindestens einer Richtung im Bereich von 2 bis 35 %, bezogen auf die Länge der Faser-umfassenden Schicht in dieser Richtung aufweisen kann. Es wird nicht gelehrt, die Perforation vorzunehmen, um die Dehnbarkeit zu verbessern.

Die WO 2008/130201 A2 lehrt, zur Abschirmung elektromagnetischer Wellen ein Laminat zu verwenden, das eine Polymerharzschicht und wenigstens eine Metallfolienschicht umfasst. Dieses Laminat soll sich gegenüber einer reinen Metallfolie durch eine gute Zugstabilität und Flexibilität auszeichnen. Ausführungsformen der Erfindung betreffen Laminate, bei denen eine Oberfläche oder beide Oberflächen geprägte Bereiche aufweisen oder Laminate, die perforierte Bereiche aufweisen. Der Durchmesser der perforierten Bereiche liegt bevorzugt in einem Bereich von 10 µm bis 5 mm. Hierbei handelt es sich somit um das Einbringen von Löchern mit einem bestimmten Durchmesser in das Laminat, d. h. um Stanzen, bei denen Material aus dem Laminat entfernt wird. Durch die geprägten und/oder perforierten Bereiche soll dem Laminat eine Flexibilität, vergleichbar einem Metall-Gewebe, verliehen werden. Dieses Dokument lehrt weder, zur Verbesserung der Flexibilität ein Laminat mit Einschnitten, zumindest in die Metallfolie, zu versehen, noch, dass die Geometrie dieser Einschnitte einen Einfluss auf die mechanischen Eigenschaften haben kann.

Die WO 2008/127077 A1 beschreibt ein wärmeleitfähiges Schichtmaterial zur Abschirmung elektromagnetischer Wellen, das eine elastische Trägerschicht und wenigstens eine darauf laminierte leitfähige Schicht umfasst. Die elastische Trägerschicht weist ein Muster aus einer Vielzahl perforierter Bereiche auf, und die leitfähige Schicht weist leitfähige Ausbuchtungen auf, die durch Einschnitte in die leitfähige Schicht gebildet werden und die koaxial zu den perforierten Bereichen der elastischen Trägerschicht sind. Die leitfähigen Ausbuchtungen sind zur Rückseite der elastischen Trägerschicht hin umgefaltet, so dass sie die perforierten Bereiche der Trägerschicht durchqueren und ragen aus der Rückseite der elastischen Trägerschicht hervor, so dass sie in Kontakt mit der Rückseite der elastischen Trägerschicht kommen. Somit soll eine thermische Leitfähigkeit in Richtung der z-Achse erzielt werden. Auch dieses Dokument lehrt nicht, zur Verbesserung der Flexibilität ein Laminat mit Einschnitten zu versehen, bei denen kein Material aus dem Laminat entfernt wird, und dass die Geometrie dieser Einschnitte einen Einfluss auf die mechanischen Eigenschaften hat.

Die US2013/285846A1 offenbart ein flexibles Laminat zur Abschirmung elektromagnetischer Strahlung gemäß dem Oberbegriff des Anspruchs 1. Zusammengefasst, weisen die im Stand der Technik beschriebenen Laminate wenigstens einen der folgenden Nachteile auf:
- Einfache Laminate aus wenigstens einer Trägerschicht, z. B. einer Polymerfolie oder einer faserhaltigen Schicht, und wenigstens einer Metallschicht eignen sich nur sehr eingeschränkt zur Ummantelung von dreidimensionalen Gebilden zur Abschirmung von elektromagnetischen Wellen, insbesondere von Gebilden mit komplexer Struktur. Es mangelt diesen Laminaten speziell an einer hohen Dehnbarkeit bei geringem Kraftaufwand.
- Auch die bekannten perforierten oder gestanzten Laminate weisen häufig keine gute Dehnbarkeit in mehr als einer Raumrichtung auf. Bei zu hoher Kraftanwendung bei der Ummantelung von dreidimensionalen Gebilden können die Laminate unkontrolliert Reißen. Im Bereich solcher Risse kann die elektromagnetische Abschirmung stark beeinträchtigt sein. Das Anbringen von Perforationen oder Stanzungen, die es nicht erlauben, das Laminat mit geringem Kraftaufwand zu dehnen, kann bei Zugbeanspruchung zu einem unerwünschten Weiterreißen führen.

Es besteht daher ein Bedarf an Laminaten, die die zuvor genannten Nachteile vermindern oder vermeiden. Sie sollen speziell eine gute elektromagnetische Abschirmung mit einem guten Drapierverhalten verbinden. Sie sollen sich weiterhin zur Herstellung von abgeschirmten Bauteilen eignen, ohne dass sie vorgeformt werden müssen. Vorzugsweise soll es möglich sein, die abzuschirmenden Bauteile in einem Vorgang zu formen und mit dem Laminat zur Abschirmung elektromagnetischer Strahlung zu verbinden. Dazu zählen spezielle Spritzgussverfahren, wie das Hinterspritzen und der Mehrkomponenten-Spritzguss, oder Umformverfahren, wie das Thermoformen. Insbesondere sollen sich die erfindungsgemäßen Laminate für den Einsatz in einem Verfahren zur Herstellung von Faser-Verbundwerkstoffen, speziell einem SMC-Verfahren (Fließpressen von Sheet Molding Compounds), eignen.

Der vorliegenden Erfindung liegt die Aufgabe zugrunde, Laminate zur Abschirmung elektromagnetischer Strahlung und ein Verfahren zur Herstellung von gegenüber elektromagnetischer Strahlung abgeschirmten Bauteilen zur Verfügung zu stellen, die die zuvor beschriebenen Nachteile überwinden.

Im Bereich der schichtförmigen Laminate auf Basis von Metallfolien zur Abschirmung elektromagnetischer Wellen war es bisher nicht bekannt, dass man ein Material mit Einschnitten bestimmter Geometrie versehen kann, um die anwendungstechnischen Eigenschaften zu verbessern. Die WO 2016/169948 A1 beschreibt, im Bereich der Wundversorgung eine selbstklebende Wundauflage aus einem Fasermaterial einzusetzen, die zwei Gruppen von Einschnitten bestimmter Geometrie aufweist. Diese Wundauflage zeichnet sich durch eine bessere Flexibilität, speziell auch im durchfeuchteten Zustand, und eine verbesserte Flüssigkeitsabgabe aus.

Überraschenderweise wurde nun gefunden, dass die zuvor genannte Aufgabe durch ein Laminat zur Abschirmung elektromagnetischer Strahlung gelöst wird, das a) wenigstens eine Metallfolie, und b) ein flächiges Substrat als Trägermaterial umfasst, wobei das Laminat eine Vielzahl von Einschnitten in die Grundfläche aufweist, die eine bestimmte räumliche Anordnung aufweisen.

### ZUSAMMENFASSUNG DER ERFINDUNG

Ein erster Gegenstand der Erfindung ist ein flexibles Laminat zur Abschirmung elektromagnetischer Strahlung, umfassend
a) wenigstens eine Metallfolie, und
b) ein flächiges Substrat, umfassend oder bestehend aus einem Faser-, Folien- oder Schaummaterial,
wobei das Laminat eine Vielzahl von aus Einschnitten in die Grundfläche des Laminats gebildeten Objekten aufweist, wobei jedes Objekt aus zwei oder mehreren Einschnitten besteht, die einen gemeinsamen Anfangspunkt aufweisen, und wobei die zwei Einschnitte oder je zwei benachbarte Einschnitte einen Winkel von 45 bis 160° aufweisen.

In einer speziellen Ausführung umfasst jedes Objekt einen, zwei oder mehrere geradlinige Einschnitte. Insbesondere besteht jedes Objekt aus zwei oder mehreren geradlinige Einschnitten.

Die Einschnitte durchtrennen das Laminat jeweils vollständig. Darunter wird verstanden, dass die wenigstens eine Metallfolie a) und das flächige Substrat b) beide vollständig durchtrennt werden. Weist das erfindungsgemäße Laminat mehr als eine, z. B. 2, 3 ,4 ,5 oder mehr als 5 Metallfolien a), auf, so werden durch die Einschnitte alle Metallfolien jeweils vollständig durchtrennt.

Ein weiterer Gegenstand der Erfindung ist ein Verfahren zur Herstellung eines gegenüber elektromagnetischer Strahlung abgeschirmten Bauteils, bei dem man:
i.1) ein Laminat, wie zuvor und im Folgenden definiert, und wenigstens ein Polymermaterial (c) oder eine Vorstufe davon bereitstellt,
ii.1) das Laminat und das Polymermaterial (c) oder dessen Vorstufe einer Formgebung unter Verbindung der Materialen unterzieht, und dabei, falls vorhanden, die Vorstufe zur Polymerisation bringt,
   oder
i.2) ein Laminat, wie zuvor und im Folgenden definiert, und wenigstens ein Bauteil bereitstellt,
ii.2) das Bauteil teilweise oder vollständig mit dem Laminat beschichtet oder ummantelt.

Speziell wird das gegenüber elektromagnetischer Strahlung abgeschirmte Bauteil durch ein Verfahren nach der 1. Variante hergestellt, wobei die Verbindung zwischen dem Laminat und dem Polymermaterial (c) durch ein SMC-Verfahren oder ein Hinterspritz-Verfahren oder ein Thermoform-Verfahren hergestellt wird.

Ein weiterer Gegenstand der Erfindung ist ein elektromagnetisch abgeschirmtes Bauteil, das ein erfindungsgemäßes Laminat, wie zuvor und im Folgenden definiert, umfasst, oder das durch ein Verfahren, wie zuvor und im Folgenden definiert, erhältlich ist.

Ein weiterer Gegenstand der Erfindung ist die Verwendung des Laminats, wie zuvor und im Folgenden definiert, zur Abschirmung elektromagnetischer Strahlen, bevorzugt von stromführenden Systemen und Stromspeichern, besonders bevorzugt in elektronischen Gehäusen. Bevorzugte Einsatzbereiche sind in Elektrofahrzeugen, Luftfahrzeugen, Raumfahrzeugen, bevorzugt in Elektrofahrzeugen und Drohnen.

### BESCHREIBUNG DER ERFINDUNG

Bei den erfindungsgemäßen Laminaten handelt es sich um flächenförmige Gebilde, die über eine im Wesentlichen zweidimensionale, ebene Ausdehnung und eine demgegenüber geringere Dicke verfügen. Zur ihrer Beschreibung kann ein orthogonales Koordinatensystem verwendet werden, wobei die Grundfläche des Laminats in der von der x-Achse und der aufgespannten Ebene (auch als x,y-Ebene bezeichnet) liegt. Die dazu orthogonale z-Achse kann zur Beschreibung der Materialdicke dienen.

Die erfindungsgemäßen Laminate sind flexibel, d. h. sie weisen in Bezug auf die Grundfläche des Laminats (in der x,y-Ebene) eine gute Dehnbarkeit in mehr als einer Raumrichtung auf. Diese Flexibilität wird erzielt durch Einschnitte in die Grundfläche des Laminats. Die Einschnitte erfolgen vorzugsweise im Wesentlichen in Richtung der zur Grundfläche orthogonalen z-Achse. Bevorzugt beträgt der Schnittwinkel bezogen auf die Grundfläche des Laminats (d.h. die x,y-Ebene) 10° bis 90°, besonders bevorzugt 30 bis 90°, insbesondere 60 bis 90°, speziell 80 bis 90°. In einer bevorzugten Ausführungsform handelt es sich bei dem erfindungsgemäßen flexiblen Laminat um ein Faserverbundmaterial. Gemäß der für Faserverbundmaterialien üblichen Beschreibung weisen die erfindungsgemäßen Laminate eine gute Flexibilität (Dehnbarkeit) nicht nur in Richtung der x-Achse als der Rollenrichtung (machine direction, MD), sondern auch in Richtung der y-Achse, d.h. orthogonal zur Rollenrichtung (cross machine direction, CMD), auf. Im Zugkraft-Längenänderungsdiagramm zeigt sich, dass die erfindungsgemäßen Laminate sowohl in Rollenrichtung als auch orthogonal zur Rollenrichtung bereits bei geringen Zugkräften eine große Dehnung aufweisen. Dies ist ein Vorteil gegenüber aus dem Stand der Technik bekannten Laminaten zur Abschirmung elektromagnetischer Strahlung.

Ein Stoffschluss wird durch atomare oder molekulare Kräfte zwischen den Verbindungspartnern gebildet. Zu den stoffschlüssigen Verbindungen von Kunststoffen zählen die Klebeverbindungen und Schweißverbindungen; auch Spritzgussverfahren führen zu stoffschlüssigen Verbindungen. Ein Stoffschluss ist eine in der Regel nicht lösbare Verbindung. Formschlüssige Verbindungen entstehen durch das Ineinandergreifen von mindestens zwei Verbindungspartnern. Dadurch können sich die Verbindungspartner auch ohne oder bei unterbrochener Kraftübertragung nicht lösen. Kraftschlüssige Verbindungen setzen eine Normal-Kraft auf die miteinander zu verbindenden Flächen voraus. Ihre gegenseitige Verschiebung ist verhindert, solange die durch die Haftreibung bewirkte Gegen-Kraft nicht überschritten wird.

Im Rahmen der Erfindung bezeichnet ein Einschnitt ein vollständiges Durchtrennen der Metallfolie und des flächigen Substrats, ohne dass hierbei bewusst Material aus der Metallfolie oder dem Substrat entnommen wird. Es können übliche Schneideverfahren, wie Messer- oder Laserschnittverfahren, zum Einsatz kommen.

Erfindungsgemäß weist das Laminat eine Vielzahl von aus Einschnitten in die Grundfläche des Laminats gebildeten Objekten auf, wobei jedes Objekt aus zwei oder mehreren geradlinigen Einschnitten besteht, die einen gemeinsamen Anfangspunkt aufweisen. Es ist prinzipiell möglich, dass sich die Einschnitte, die ein Objekt bilden, nicht (oder bei wenigstens drei Einschnitten nicht alle) in dem gemeinsamen Anfangspunkt treffen. Der gemeinsame Anfangspunkt ist dann ein imaginärer Punkt, in dem sich alle Linien treffen, die man erhält, wenn man die Einschnitte über ihre realen Endpunkte hinaus extrapoliert. Dann beträgt der Abstand der Endpunkte der Einschnitte, die jeweils dem gemeinsamen Anfangspunkt am nächsten liegen, zum Anfangspunkt höchstens 2 mm, bevorzugt höchstens 1 mm, insbesondere höchstens 0,5 mm. Bevorzugt treffen sich alle Einschnitte, die ein Objekt bilden, in dem gemeinsamen Anfangspunkt.

Die Einschnitte können mit üblichen Verfahren, z. B. mit Schneidewerkzeugen (Stanzmessern) oder durch Laser, erzeugt werden. Durch die geradlinigen Einschnitte wird das Laminat vollständig durchtrennt ohne dass Material aus dem Laminat entnommen wird. Bevorzugt ist das Anbringen der Schnitte mittels Stanzwerkzeugen.

Die erfindungsgemäßen Laminate können Einschnitte im gesamten Bereich ihrer Grundfläche oder in wenigstens einem Teilbereich aufweisen. Die Bereiche des Laminats, die Einschnitte aufweisen, zeichnen sich durch hohe Dehnungswerte bei geringem Kraftaufwand in mehr als einer Raumrichtung aus. Die Einschnitte werden dabei so angebracht, dass man drapierfähige Produkte erhält, die sich optimal an die Form der elektrisch abzuschirmenden Bauteile anpassen. Wenn es die Geometrie der Bauteile zulässt, dass nur bestimmte Bereich des Laminats verformt werden müssen, so ist es ausreichend, nur in diesen Bereichen Einschnitte anzubringen. Somit wird sichergestellt, dass die mit den erfindungsgemäßen Laminaten ausgerüsteten Bauteile in allen erforderlichen Bereichen über eine gute elektromagnetische Abschirmung verfügen. Vorteilhafterweise müssen die Laminate nicht vorgeformt werden und eignen sich sowohl zu einer Ummantelung von Bauteilen, ohne dass eine stoffschlüssige Verbindung besteht, als auch zum Einsatz in einem Formungsverfahren, in dem das Bauteil geformt und gleichzeitig (in der Regel stoffschlüssig) mit dem Laminat verbunden wird. Die Einschnitte können geradlinig oder krummlinig, z.B. kreisförmig oder nicht kreisförmig, sein. Bevorzugt besteht jedes Objekt aus zwei oder mehreren geradlinigen Einschnitten.

Erfindungsgemäß weisen die zwei Einschnitte eines Objekts oder je zwei benachbarte Einschnitte eines Objekts einen Winkel von 45 bis 160° auf. Bevorzugt weisen die zwei Einschnitte oder je zwei benachbarte Einschnitte einen Winkel von 55 bis 140° auf. Bei krummlinigen Einschnitten bezieht sich der Winkel auf die Tangente an den Einschnitt im gemeinsamen Anfangspunkt der Einschnitte.

Bevorzugt wird ein Objekt aus je 2, 3, 4, 5 oder 6 Einschnitten, besonders bevorzugt 2, 3 oder 4 Einschnitten, gebildet.

Bevorzugt wird ein Objekt aus x Einschnitten gebildet, wobei x für 3, 4, 5 oder 6 steht und je zwei benachbarte Einschnitte einen Winkel von etwa (360/x)° aufweisen. Dabei können die Winkelmaße sowohl exakt gleich sein als auch eine Abweichung von der Gleichverteilung von etwa +/- 20 Grad, bevorzugt von etwa +/- 10 Grad, speziell von +/- 5 Grad, aufweisen. Bevorzugt ist eine exakte Gleichverteilung der Winkelmaße.

In einer ersten speziellen Ausführungsform wird ein Objekt von drei Einschnitten gebildet. Dann weisen vorzugsweise je zwei benachbarte Einschnitte des Objekts einen Winkel von 110 bis 130° auf. Speziell betragen alle drei Winkel, die die Schnitte miteinander bilden, 120°.

In einer zweiten speziellen Ausführungsform wird ein Objekt von vier Einschnitten gebildet. Dann weisen vorzugsweise je zwei benachbarte Einschnitte des Objekts einen Winkel von 80 bis 100° auf. Speziell betragen alle vier Winkel, die die Schnitte miteinander bilden, 90°.

Bevorzugt weisen die aus den Einschnitten gebildeten Objekte eine Symmetrie auf, die ausgewählt ist unter:
- einer wenigstens 3-zähligen Rotationssymmetrie,
- einer Achsensymmetrie mit wenigstens zwei Spiegelsymmetrieachsen,
- einem Inversionszentrum,
- einer mindestens 3-zähligen Drehspiegelachse.

Bevorzugt weisen alle Objekte eine Symmetrie auf, die aus den zuvor Genannten ausgewählt ist. In einer speziellen Ausführungsform weisen alle Objekte dieselbe Symmetrie auf.

Bevorzugt sind die aus Einschnitten in die Grundfläche des Laminats gebildeten Objekte in Gruppen angeordnet, wobei eine Gruppe von Objekten dadurch gekennzeichnet ist, dass alle gemeinsamen Anfangspunkte der Objekte der Gruppe auf einer Geraden liegen. Bevorzugt weisen alle Objekte einer Gruppe identische Form und Größe auf. Speziell weisen alle Objekte einer Gruppe identische Form, Größe und räumliche Anordnung (Orientierung) auf. Identische Orientierung bedeutet, dass alle Objekte einer Gruppe in identischer Weise ausgerichtet sind.

Eine spezielle Ausführungsform ist ein Laminat, wobei die Objekte Gruppen bilden, wobei
- alle Objekte einer Gruppe identische Form, Größe und räumliche Anordnung aufweisen, und
- die gemeinsamen Anfangspunkte aller Objekte einer Gruppe auf einer Geraden liegen.

Bevorzugt weisen die in Gruppen längs einer Geraden durch ihre Anfangspunkte angeordneten Objekte als übergeordnetes Strukturprinzip ein Muster auf. Speziell bilden die Gruppen ein Muster, wobei
- ein Muster 1, 2, 3, 4, oder mehr als 4 Gruppen von Objekten umfasst,
- alle Geraden, auf denen die Objekte liegen, parallel angeordnet sind,
- die Gruppen in orthogonaler Richtung zu den Geraden eine regelmäßige Abfolge aufweisen.

In einer speziellen Ausführung weisen alle Objekte identische Form und Größe auf.

Bevorzugt liegt die Länge der Einschnitte in einem Bereich von 1 bis 40 mm, besonders bevorzugt 1,5 bis 20 mm, insbesondere 2 bis 15 mm, speziell 2 bis 10 mm.

Bevorzugt liegt der Mindestabstand zwischen zwei Objekten in einem Bereich von 0,1 bis 15 mm, besonders bevorzugt 0,3 bis 12 mm, insbesondere 0,5 bis 5 mm.

Das erfindungsgemäße flexible Laminat zur Abschirmung elektromagnetischer Strahlung umfasst als Komponente a) wenigstens eine Metallfolie.

Die Komponente a) kann eine oder mehr als eine, z. B. 2, 3, 4, 5 oder mehr als 5 Metallfolien umfassen oder daraus bestehen. In einer bevorzugten Ausführung umfasst die Komponente a) 1, 2 oder 3 Metallfolien. Wenn die Komponente a) mehr als eine Metallfolie umfasst, so kann sich jeweils zwischen zwei Metallfolien eine haftvermittelnde Schicht befinden. Bevorzugt umfasst die haftvermittelnde Schicht wenigstens ein Polymer, vorzugsweise ausgewählt unter Thermoplasten oder härtbaren Polymerzusammensetzungen. Geeignete härtbare Polymersysteme können auf den dafür bekannten Polyestern, Polyurethanen, Epoxiden und Silikonen beruhen. Bevorzugte Thermoplaste sind Polyester, Polyamide, Polyolefine und Mischungen davon.

Bevorzugte Polyester sind Polyethylenterephthalat und Polybutylenterephthalat. Bevorzugte Polyolefine sind Polyethylen oder Polypropylen.

Das Metall der Metallfolie ist vorzugsweise ausgewählt unter Aluminium, Titan, Magnesium, Zinn, Nickel, Kupfer, Silber, Gold, etc. Geeignet sind auch Metalllegierungen, bevorzugt µ-Metall (Permalloy). Besonders bevorzugt umfasst die Metallfolie Aluminium oder besteht aus Aluminium.

Bevorzugt weist die Metallfolie eine Dicke von 3 bis 250 µm, besonders bevorzugt von 5 bis 225 µm, insbesondere von 7 bis 200 µm, auf.

Das erfindungsgemäße flexible Laminat zur Abschirmung elektromagnetischer Strahlung umfasst als Komponente b) ein flächiges Substrat, das ein Faser-, Folien- oder Schaummaterial umfasst oder daraus besteht.

Das Substrat b) kann ein- oder mehrlagig aufgebaut sein. Eine spezielle Ausführungsform ist ein mehrlagig aufgebautes Substrat b).

In einer bevorzugten Ausführungsform umfasst die Komponente b) wenigstens ein Fasermaterial. Bevorzugt liegt das Fasermaterial als ein- oder mehrlagiges Flächengebilde vor. Dieses Flächengebilde weist vorzugsweise wenigstens eine Lage auf, die ausgewählt ist unter Vliesstoffen, Gelegen, Geweben, Gestricken, Gewirken, Papieren und Kombinationen davon. Bevorzugt umfasst das Substrat b) ein ein- oder mehrlagiges Fasermaterial, das vorzugsweise ausgewählt ist unter Vliesstoffen, Papieren, Geweben und Kombinationen davon. Besonders bevorzugt umfasst die Komponente b) wenigstens eine Lage, bei der es sich um einen Vliesstoff handelt.

Im Sinne der Erfindung bezeichnet "Vliesstoff" ein Gebilde aus Fasern begrenzter Länge, Endlosfasern (Filamenten) oder geschnittenen Garnen jeglicher Art und jeglichen Ursprungs, die auf irgendeine Weise zu einer Faserschicht oder einem Faserflor zusammengefügt und auf irgendeine Weise miteinander verbunden worden sind; davon ausgeschlossen ist das Verkreuzen bzw. Verschlingen von Garnen, wie es beim Weben, Wirken, Stricken, der Spitzenherstellung, dem Flechten und Herstellung von getufteten Erzeugnissen geschieht. Nicht zu den Vliesstoffen gehören Folien und Papiere.

Die zur Herstellung des Flächengebildes eingesetzten Fasern können Filamente, Stapel- und/oder Kurzschnittfasern sein. Erfindungsgemäß bevorzugt sind die Fasern Stapelfasern und/oder Kurzschnittfasern. Stapelfasern bzw. Kurzschnittfasern können durch die verschiedensten bekannten Herstellungsverfahren gefertigt und gelegt werden, beispielsweise Kardierverfahren, Airlaid- und Wetlaid-Verfahren.

In einer ersten geeigneten Ausführungsform umfasst das Substrat b) wenigstens einen mechanisch gebundenen Vliesstoff. Bei mechanisch gebundenen Vliesstoffen wird ein Faserflor z. B. durch eine Nadeltechnik oder mittels Wasser- oder Dampfstrahlen verfestigt.

In einer weiteren geeigneten Ausführungsform umfasst das Substrat b) wenigstens einen thermisch gebundenen Vliesstoff. Thermisch gebundene Vliesstoffe können z. B. durch Pressen unter erhöhter Temperatur, beispielsweise mittels Kalander oder durch Heißluft, verfestigt werden. Der Faserflor thermisch gebundener Vliesstoffe umfasst in der Regel Fasern aus Polyester oder Polyamid.

In einer weiteren geeigneten Ausführungsform umfasst das Substrat b) wenigstens einen chemisch gebundenen Vliesstoff. Bei chemisch gebundenen Vliesstoffen wird der Faserflor durch Imprägnieren, Besprühen oder mittels sonst üblicher Auftragsmethoden mit einem Binder (z. B. Acrylatbinder) versehen und anschließend gehärtet. Der Binder bindet die Fasern untereinander zu einem Vliesstoff.

In einer bevorzugten Ausführungsform umfasst das Substrat b) wenigstens ein Spinnvlies (Spunbond). Zur Herstellung von Spinnvlies werden Endlosfasern (Filamente) abgelegt und können dann z. B. durch Behandlung mit beheizten Walzen oder durch Dampfstrom/Heißluft verfestigt werden. Bei der Verfestigung durch Walzen ist meist eine der beiden Walzen mit einer Gravur versehen, die z. B. aus kreis-, rechteck- oder rautenförmigen Punkten bestehen. An den Kontaktpunkten verschmelzen die Fäden und bilden so den Vliesstoff. Eine spezielle Ausführung ist ein thermisch verfestigtes Spinnvlies.

Wenn das Substrat b) wenigstens einen Vliesstoff aufweist, so kann das Flächengewicht in weiten Bereichen variieren. Bevorzugt ist ein Flächengewicht gemäß DIN EN 29073-1:1992-08 von 10 bis 400 g/m², vorzugsweise von 15 bis 300 g/m², insbesondere von 20 bis 250 g/m².

Als weitere Ausführungsform kann die Komponente b) ein Folienmaterial umfassen. Geeignete Folienmaterialen sind Thermoplaste, wie Polyolefine, z. B. Polyethylen oder Polypropylen, Polyester, z. B. Polyethylenterephthalat, Polybutylenterephthalat oder Polyethylennaphthalat, Polyamid, Polyacrylat, etc. In einer speziellen Ausführungsform weist das Substrat b) wenigstens eine Polymerfolie in Kombination mit wenigstens einem Fasermaterial auf. Die Komponente b) kann dann das Folienmaterial als eine Verstärkungslage für die Fasermaterialen aufweisen. Somit werden Substrate b) mit hoher mechanischer Festigkeit und geringem Gewicht erhalten. Möglich ist auch, dass das Folienmaterial und die Fasermaterialen durch Laminieren unter Erhitzen und/oder Druck stoffschlüssig miteinander verbunden werden. Dies kann unabhängig von oder vorzugsweise gemeinsam mit der Herstellung des Laminats aus der/den Metallfolie(n) a) und dem flächigen Substrat b) erfolgen.

Hierbei werden Fasermaterialien, speziell Vliesstoff und Folie, so miteinander verbunden, dass 2-, 3- oder mehrlagige Laminate, z. B. mit dem Aufbau Vliesstoff-Folie oder Vliestoff-Folie-Vliesstoff, erhalten werden. Zur Herstellung von Laminaten kann dann wenigstens eine Faservlieslage mit wenigstens einer Polymerlage in Verbindung gebracht werden und dann die Kombination unter Erhitzen verpresst werden. Dabei werden die Polymere bevorzugt soweit aufgeschmolzen, dass sie zumindest teilweise Poren und Zwischenräume zwischen den Fasern ausfüllen.

Als weitere Ausführungsform kann die Komponente b) einen Schaum umfassen. Ein Schaum im Sinne der Erfindung ist eine poröse, zumindest teilweise offenzellige Struktur mit miteinander kommunizierenden Zellen. Geeignete sind z. B. Polyurethanschäume. Polyurethanschäume können in bekannter Weise aus Polyisocyanaten, Polyolen und gegebenenfalls wenigstens einem weiteren Comonomer hergestellt werden. Geeignet sind z. B. Polyester-Polyurethane und Polyether-Polyurethane.

Das Substrat b) kann zusätzlich wenigstens ein Additiv enthalten. Geeignete Additive sind zum einen Füllstoffe und Verstärkungsstoffe. Dazu zählen partikuläre Füllstoffe, Faserstoffe und beliebige Übergangsformen. Partikuläre Füllstoffe können eine weite Bandbreite von Teilchengrößen aufweisen, die von staubförmigen bis grobkörnigen Partikeln reichen. Als Füllmaterial kommen organische oder anorganische Füll- und Verstärkungsstoffe in Frage. Beispielsweise können anorganische Füllstoffe, wie Carbonfasern, Kaolin, Kreide, Wollastonit, Talkum, Calciumcarbonat, Silikate, Titandioxid, Zinkoxid, Glaspartikel, z. B. Glaskugeln, nanoskalige Schichtsilikate, nanoskaliges Aluminiumoxid (Al₂O₃), nanoskaliges Titandioxid (TiO₂), Schichtsilikate und nanoskaliges Siliciumdioxid (SiO₂), eingesetzt werden. Die Füllstoffe können auch oberflächenbehandelt sein. Geeignete Schichtsilikate sind Kaoline, Serpentine, Talkum, Glimmer, Vermiculite, Illite, Smectite, Montmorillonit, Hectorit, Doppelhydroxide und Gemische davon. Die Schichtsilikate können oberflächenbehandelt oder unbehandelt sein. Weiterhin können ein oder mehrere Faserstoffe zum Einsatz kommen. Diese sind vorzugsweise ausgewählt aus bekannten anorganischen Verstärkungsfasern, wie Borfasern, Glasfasern, Kieselsäurefasern, Keramikfasern und Basaltfasern; organischen Verstärkungsfasern, wie Aramidfasern, Polyesterfasern, Nylonfasern und Polyethylenfasern und Naturfasern, wie Holzfasern, Flachsfasern, Hanffasern und Sisalfasern.

Geeignete Additive sind weiterhin ausgewählt unter Antioxidantien, Wärmestabilisatoren, Flammschutzmitteln, Lichtschutzmitteln (UV-Stabilisatoren, UV-Absorber oder UV-Blocker), Katalysatoren für die Vernetzungsreaktion, Verdickern, thixotropen Agentien, oberflächenaktiven Agentien, Viskositätsmodifikatoren, Gleitmitteln, Farbstoffen, Nukleierungsmitteln, Antistatika, Entformungsmitteln, Entschäumern, Bakteriziden, etc..

Das Substrat b) kann wenigstens ein Bindemittel enthalten. Bindemittel dienen z. B. zur Verbesserung der Haftung von Fasermaterialien, speziell Vliesstoffen. Sie dienen weiterhin zur Verbesserung der Haftung zwischen verschiedenen Lagen des Substrats b), z. B. zwischen zwei Vliesstofflagen. Bindemittel dienen weiterhin zur Verbesserung der Haftung von in der Komponente b) eingesetzten Füll- und Verstärkungsstoffen und weiteren Additiven. Geeignete Bindemittel umfassen wenigstens ein Polymermaterial, vorzugsweise ausgewählt unter Polyvinylalkohol, Polyacrylaten, Polyurethanen, Styrol-Butadien-Kautschuk, Nitril-Butadien-Kautschuk, Polyester-, Epoxid- und Polyurethanharzen.

In einer bevorzugten Ausführungsform umfasst das Substrat b) wenigstens zwei Schichten, wobei eine der Schichten als Verstärkungseinlage (scrim) ausgebildet ist. Durch den Einsatz von Verstärkungseinlagen kann beispielsweise die Haftung zwischen den beiden angrenzenden Lagen erhöht werden. Geeignete Materialen für die Verstärkungseinlage sind die zuvor als Fasermaterialien genannten. Speziell wird ein Polyester eingesetzt. Geeignet als Verstärkungseinlage sind allgemein die dafür beschriebenen Flächengebilde aus Fasern mit sich in zwei Richtungen kreuzenden Fäden. Diese weisen in der Regel ein deutlich geringeres Flächengewicht auf als die zuvor beschriebenen Vliesstoffe. Das Flächengewicht der Verstärkungseinlage liegt vorzugsweise in einem Bereich von 1 bis 100 g/m², vorzugsweise von 1 bis 50 g/m², insbesondere von 2 bis 25 g/m².

Bevorzugt weist das Substrat b) eine Dicke von 50 bis 1500 µm, besonders bevorzugt von 100 bis 1000 µm, insbesondere von 150 bis 800 µm, auf.

In einer konkreten Ausführungsform wird zur Herstellung des Substrats b) ein Vliesstoffmaterial, bevorzugt ein Spinnvlies, insbesondere ein Polyester-Spinnvlies, eingesetzt und in einem Laminierungsverfahren mit wenigstens einem Polymermaterial als Bindemittel zu einem mehrschichtigen Verbundmaterial verbunden. Diese Herstellung erfolgt nach üblichen, dem Fachmann bekannten Verfahren, z. B. Thermobonding oder Extrusion. Beim Thermobonding werden mittels einer Prägewalze punktuell Polymermaterial und/oder Vliesstoff durch hohe Temperatur und Druck plastifiziert, wobei sich eine Verbindung der beiden Materialbahnen ergibt. Bevorzugt ist die Extrusion. So können z. B. zur Herstellung eines Vliesstoff-Folie-Substrats mit dem Aufbau Vliesstoff-Folie-Vliesstoff zwei Vliesmaterialbahnen mittels eines Binders verbunden werden. Dabei kann zumindest auf eine Materialbahn der plastifizierte Binder extrudiert werden und anschließend mit einer weiteren Vliesmaterialbahn zusammengeführt werden, woran sich ein Verpressen und Abkühlen anschließt. Möglich ist auch, dass durch zwei Materialbahnen ein Walzenspalt gebildet wird, in den der Binder extrudiert, mit den Materialbahnen verpresst und abgekühlt wird. Nach diesen Verfahren lassen sich durch Wiederholung der Extrusions- und Härtungsschritte viellagige Substrate b) herstellen, wobei die Schichtfolge der Vliesstoffschichten und Polymerschichten variieren kann. Werden mehrere Vliesstoffschichten und/oder mehrere Binderschichten vorgesehen, so können diese die gleiche Zusammensetzung oder verschiedene Zusammensetzungen, z. B. hinsichtlich der Art des Binders, der Art des Fasermaterials, der Materialmenge, etc., aufweisen. Durch Steuerung der Extrusionsbedingungen, z. B. der Auftragsmenge an Binder, der Art des Binders, der Temperatur, der Bahngeschwindigkeit und dem Liniendruck können die Materialeigenschaften beeinflusst werden. So lässt sich z. B. steuern, wie lange der Binder zwischen den Materialbahnen flüssig ist, d. h. wie gut er sich mit den beiden Materialbahnen verbinden kann. Somit lassen sich z. B. die Haftfestigkeit zwischen den Materialbahnen oder die Eindringtiefe in die Materialbahnen steuern. Die Anzahl der zu laminierenden Bahnen ist nicht begrenzt. Es muss nur für die erforderliche Erwärmung der Bahnen, z. B. über einen Heizzylinder, gesorgt werden. Prinzipiell können auch nicht nur Vliesstoffe mit Folien laminiert werden, sondern jede erdenkliche Kombination (z. B. Vliesstoff/Vliesstoff; Vliesstoff/Folie; Vliesstoff/Folie/Vliesstoff; Folie/Folie; etc.).

Die Herstellung der erfindungsgemäßen flexiblen Laminate zur Abschirmung elektromagnetischer Strahlung erfolgt, indem man wenigstens eine Metallfolie a) und wenigstens ein flächiges Substrat b) oder deren Vorstufen in einem Laminierverfahren miteinander verbindet. Diese Verbindung ist in der Regel eine stoffschlüssige Verbindung. Alternativ oder zusätzlich kann eine form- und/oder kraftschlüssige Verbindung erfolgen. In dem Verfahren können einzelne Komponenten, z. B. mehrere mit einem Binder verbundene Metallfolien, mehrere mit einem Binder versehene Fasermaterialien, als Vorstufen (Zwischenprodukte) hergestellt und anschließend zu dem endgültigen Laminat verbunden werden. Als Binder können nicht härtbare oder härtbare Polymersysteme in Form von Ein- oder Mehrkomponentensystemen eingesetzt werden.

Die Laminierung, sei es in mehreren Einzelschritten oder in einem Schritt, erfolgt in der Regel bei erhöhter Temperatur und/oder unter erhöhtem Druck. Geeignet sind die bereits zuvor beschriebenen Verfahren. So kann man beispielsweise die zu laminierenden Komponenten schichtförmig als Bahnmaterial durch einen oder mehrere Walzenspalten führen. Des Weiteren kann man beispielsweise die zu laminierenden Komponenten in Form eines Stapels bei hoher Temperatur und hohem Druck für einen Zeitraum pressen, der ausreicht, um den Binder zu plastifizieren und gegebenenfalls zu härten und ein Laminat zu bilden.

Die erfindungsgemäßen Laminate weisen eine hohe Beständigkeit gegenüber einem Weiterreißen, sowohl ausgehend von den in den Laminaten befindlichen Einschnitten, als auch bei einer unerwünschten Beschädigung beim Ummanteln oder Verbinden mit wenigstens einem Bauteil auf. In Weiterreißversuchen wird der Widerstand eines Einschnitts gegen Weiterreißen bei einer Zugbeanspruchung bestimmt. Mit dem Trapezweiterreißversuch nach DIN EN ISO 9073-4:1997-04 wird die Weiterreißfestigkeit von Einschnitten in beschichteten Geweben und Vliesstoffen bestimmt. Die Trapezweiterreißkraft ist die höchste Zugkraft, die bei der Zugbeanspruchung der Messprobe auftritt, um den Einschnitt weiter zu reißen.

Bevorzugt weisen die erfindungsgemäßen Laminate eine Weiterreißkraft, bestimmt nach DIN EN ISO 9073-4:1997-04, im Bereich von 1 bis 100 N, bevorzugt 2 bis 80 N, insbesondere 3 bis 40 N, auf.

Ein weiterer Gegenstand der Erfindung ist ein Verfahren zur Herstellung eines gegenüber elektromagnetischer Strahlung abgeschirmten Bauteils, bei dem man:
i.1) ein Laminat, wie zuvor definiert, und wenigstens ein Polymermaterial (c) oder eine Vorstufe davon bereitstellt,
ii.1) das Laminat und das Polymermaterial (c) oder dessen Vorstufe einer Formgebung unter Verbindung der Materialen unterzieht, und dabei, falls vorhanden, die Vorstufe zur Polymerisation bringt,
   oder
i.2) ein Laminat, wie zuvor definiert, und wenigstens ein Bauteil bereitstellt,
ii.2) das Bauteil teilweise oder vollständig mit dem Laminat beschichtet oder ummantelt.

### Variante 1:

Nach der ersten Verfahrensvariante wird aus wenigstens einem Polymermaterial (c) oder dessen Vorstufe ein Bauteil gefertigt, das der elektromagnetischen Abschirmung bedarf und mit einem erfindungsgemäßen Laminat verbunden. Diese Verbindung ist in der Regel stoffschlüssig. Dabei kann die Herstellung des Laminats und des Bauteils in separaten Schritten erfolgen. Alternativ können die das Laminat formenden Komponenten und die das abzuschirmende Bauteil formenden Komponenten in einem einzigen Schritt miteinander verbunden werden.

Polymermaterialien (c) im Sinne der Erfindung sind Materialien, die wenigstens ein Polymer enthalten oder aus wenigstens einem Polymer bestehen. Zusätzlich zu wenigstens einem Polymer können die Polymermaterialien (c) wenigstens eine weitere Komponente enthalten, z. B. Füllstoffe, Verstärkungsstoffe oder davon verschiedene Additive. Die Polymermaterialien (c) liegen in einer speziellen Ausführung als Komposit (Verbundwerkstoff) vor.

Bevorzugt ist die Polymerkomponente des Polymermaterials (c) ausgewählt unter Polyurethanen, Silikonen, Fluorsilikonen, Polycarbonaten, Ethylen-Vinylacetaten, Acrylnitril-Butadien-Acrylaten, Acrylnitril-Butadien-Kautschuken, Acrylnitril-Butadien-Styrolen, Acrylnitril-Methylmethacrylaten, Acrylnitril-Styrol-Acrylaten, Celluloseacetaten, Celluloseacetatbutyraten, Polysulfonen, Poly(meth)acrylaten, Polyvinylchloriden, Polyphenylenethern, Polystyrolen, Polyamiden, Polyolefinen, Polyketonen, Polyetherketonen, Polyimiden, Polyetherimiden, Polyethylenterephthalaten, Polybutylenterephthalaten, Fluorpolymeren, Polyestern, Polyacetalen, Flüssigkristallpolymeren, Polyethersulfonen, Epoxidharzen, Phenolharzen, Chlorsulfonaten, Polybutadienen, Polybutylen, Polyneoprenen, Polynitrilen, Polyisoprenen, Naturkautschuken, Styrol-Isopren-Styrolen, Styrol-Butadien-Styrolen, Ethylen-Propylenen, Ethylen-Propylen-Dien-Kautschuken, Styrol-Butadien-Kautschuken sowie deren Copolymeren und Mischungen davon.

In einer bevorzugten Ausführung wird in Schritt i.1) das Polymermaterial (c) in Form eines Verbundwerkstoffs bereitgestellt, der die Polymerkomponente des Polymermaterials (c) und wenigstens eine weitere Komponente (K) umfasst, die vorzugsweise ausgewählt ist unter Polymeren, polymeren Werkstoffen, textilen Werkstoffen, keramischen Werkstoffen, mineralischen Werkstoffen und Kombinationen davon, besonders bevorzugt ausgewählt unter verstärkten und/oder gefüllten Kunststoffmaterialien, Polymerfolien, Polymerformkörpern und Kombinationen davon.

In einer speziellen Ausführung wird in Schritt i.1) das Polymermaterial (c) in Form eines Verbundwerkstoffs bereitgestellt, das wenigstens einen faserförmigen Verstärkungsstoff umfasst, wobei die Fasern vorzugsweise ausgewählt sind unter Glasfasern, Kohlenstofffasern, Aramidfasern, Polyesterfasern und Kombinationen davon.

In einer weiteren speziellen Ausführung wird in Schritt i.1) das Polymermaterial (c) in Form eines Verbundwerkstoffs bereitgestellt, der einen faserförmigen Verstärkungsstoff umfasst, der in eine thermoplastische Kunststoffmatrix eingebettet ist (Organoblech).

In Schritt ii.1) wird das Laminat und das Polymermaterial (c) oder dessen Vorstufe einer Formgebung unter Verbindung des Laminats und des Polymermaterials unterzogen.

In einer ersten bevorzugten Ausführungsform wird ein SMC-Verfahren (Fließpress-Verfahren, SMC = Sheet Molding Compound) zur Herstellung eines gegenüber elektromagnetischer Strahlung abgeschirmten Bauteils eingesetzt. Bei der SMC-Verarbeitung kann man so vorgehen, dass man ein erfindungsgemäßes Laminat in der Kavität des Formwerkzeugs positioniert und gemeinsam mit wenigstens einem Polymermaterial einem Pressvorgang unterzieht. Dabei wird auch das Polymermaterial in Form eines flächigen Substrats eingesetzt, das durch Mischen und Konfektionieren wenigstens eines polymeren Binders, wenigstens eines Fasermaterials und gegebenenfalls wenigstes eines Additivs erhalten wird. So entsteht ein SMC-Halbzeug, das sich zusammen mit dem erfindungsgemäßen Laminat durch Fließpressen zu einem elektromagnetisch abgeschirmten Bauteil verarbeiten lässt.

In einer weiteren Ausführungsform wird ein Hinterspritz-Verfahren zur Herstellung eines gegenüber elektromagnetischer Strahlung abgeschirmten Bauteils eingesetzt. Beim Hinterspritzen werden Bauteile hergestellt, die aus einem polymeren Substrat und einem weiteren plastifizierbaren Polymermaterial bestehen. Als polymeres Substrat kann erfindungsgemäßes Laminat eingesetzt werden. Beim Hinterspritzen gibt es verschiedene Ausführungstechniken, wie Inmold decoration (IMD), Film insert molding (FIM), Inmold labeling (IML), Inmold coating (IMC) oder Inmold painting (IMP). Allen gemeinsam ist, dass das Laminat in ein Spritzgusswerkzeug eingelegt und mit einem weiteren Kunststoff hinterspritzt und geformt wird, so dass ein elektromagnetisch abgeschirmtes Bauteilteil entsteht.

In einer weiteren Ausführungsform wird ein Umform-Verfahren, speziell ein Thermoform-Verfahren, zur Herstellung eines gegenüber elektromagnetischer Strahlung abgeschirmten Bauteils eingesetzt.

### Variante 2:

Nach einer zweiten Variante des Verfahrens zur Herstellung eines gegenüber elektromagnetischer Strahlung abgeschirmten Bauteils wird im Schritt i.2) ein Laminat, wie zuvor definiert, und wenigstens ein Bauteil bereitgestellt und nachfolgend im Schritt ii.2) das Bauteil teilweise oder vollständig mit dem Laminat beschichtet oder ummantelt.

Um das Bauteil mit dem Laminat zu drapieren kann das Laminat zunächst an die Geometrie des elektromagnetisch abzuschirmenden Bauteils angepasst werden. So kann das Laminat durch Schneiden und/oder Stanzen in die gewünschte Form gebracht werden. Dabei sind alle erdenklichen Konturen möglich. Auch ist es möglich, Falzungen vorzunehmen, z. B. um ein Gehäuse zu schaffen, in welches das Bauteil eingelegt werden kann.

Ein weiterer Gegenstand der Erfindung ist ein elektromagnetisch abgeschirmtes Bauteil, das ein erfindungsgemäßes Laminat, wie zuvor und im Folgenden definiert, umfasst, oder dass durch ein Verfahren, wie zuvor und im Folgenden definiert, erhältlich ist.

Ein weiterer Gegenstand der Erfindung ist die Verwendung der erfindungsgemäßen Laminate, wie zuvor definiert, zur Abschirmung elektromagnetischer Strahlen, bevorzugt von stromführenden Systemen und Stromspeichern, besonders bevorzugt in elektronischen Gehäusen.

Die erfindungsgemäßen und nach dem erfindungsgemäßen Verfahren hergestellten Laminate und daraus hergestellten gegenüber elektromagnetischer Strahlung abgeschirmten Bauteile eignen sich vorteilhaft für den Einsatz in Elektrofahrzeugen, Luftfahrzeugen und Raumfahrzeugen. Ein bevorzugter Einsatzbereich ist die Verwendung der erfindungsgemäßen und der nach dem erfindungsgemäßen Verfahren hergestellten Laminate in Elektrofahrzeugen und Drohnen. Ein Elektrofahrzeug ist ganz allgemein ein Verkehrsmittel, das zumindest zeitweise oder teilweise mit elektrischer Energie angetrieben wird. Dabei kann die Energie im Fahrzeug erzeugt, in Batterien gespeichert oder zeitweise oder permanent von außen zugeführt werden (z. B. durch Stromschienen, Oberleitung, Induktion, etc.), wobei Kombinationen von verschiedenen Formen der Energiezufuhr möglich sind. Batteriebetriebene Fahrzeuge werden international auch als Battery Electric Vehicle (BEV) bezeichnet. Beispiele für Elektrofahrzeuge sind Straßenfahrzeuge, Schienenfahrzeuge, Wasserfahrzeuge oder Luftfahrzeuge, wie Elektroautos, Elektromotorroller, Elektromotorräder, Elektrodreiräder, Batterie- und Oberleitungsbusse, Elektrolastkraftwagen, elektrische Bahnen (Eisen- und Straßenbahnen), Elektrofahrräder und Elektroroller. Elektrofahrzeuge im Sinne der Erfindung sind auch Hybridelektrofahrzeuge (Hybrid Electric Vehicle, HEV) und Brennstoffzellenfahrzeuge (Fuel Cell (Electric) Vehicle, FC(E)V). In Brennstoffzellenfahrzeugen wird elektrische Energie aus Wasserstoff oder Methanol durch eine Brennstoffzelle erzeugt und direkt mit dem Elektroantrieb in Bewegung umgewandelt oder zeitweise in einer Batterie gespeichert.

Bei der Elektromobilität unterscheidet man vier Kernbereiche, in denen die Abschirmung elektromagnetischer Strahlen von kritischer Bedeutung ist: die Leistungselektronik, die Batterie, der E-Motor und die Navigations- und Kommunikationseinrichtungen. Die erfindungsgemäßen Laminate eignen sich in vorteilhafter Weise für die Herstellung elektronischer Gehäuse für E-Mobility-Fahrzeuge in diesen vier Bereichen.

Moderne Elektrofahrzeuge basieren auf bürstenlosen Elektromotoren, wie zum Beispiel Asynchronmaschinen oder permanenterregte Synchronmaschinen (Brushless DC-Maschine). Die Kommutierung der Versorgungsspannung in den Phasen des Motors, und damit die Erzeugung des zum Betrieb nötigen Drehfeldes, erfolgt auf elektronischem Wege durch sogenannte Wechselrichter (Inverter). Beim Bremsen fungiert der Elektromotor als Generator und liefert eine Wechselspannung, die vom Inverter gleichgerichtet und der Traktionsbatterie zugeführt werden kann (Rekuperation). Sowohl Brennstoffzellen als auch die Batterien in Elektroautos liefern höhere Spannungen als die bisher im Automotive-Sektor bekannten 12 V Gleichstrom bzw. 24 V Gleichstrom. Für viele Bauteile der Bordelektronik ist auch weiterhin ein Niedervolt-Bordnetz notwendig. Dazu werden DC/DC-Wandler eingesetzt, die hohe Spannung der Batterie in eine entsprechend niedrigere Spannung umwandeln und Verbraucher wie Klimaanlage, Servolenkung, Beleuchtung, usw. speisen. Eine weitere wichtige Leistungselektronik-Komponente im Elektroauto ist das Onboard-Ladegerät. Stromtankstellen zur Versorgung von Elektrofahrzeugen stellen entweder einphasigen oder dreiphasigen Wechselstrom oder Gleichstrom zur Verfügung. Zur Ladung der Traktionsbatterien ist zwingend Gleichstrom notwendig, welcher mit Hilfe eines Onboard-Ladegerätes durch Gleichrichtung und Wandlung des Wechselstromes erzeugt wird. Die erfindungsgemäßen Substrate eignen sich speziell für die Abschirmung elektromagnetischer Strahlen von Invertern, DC/DC-Wandlern und Onboard-Ladegeräten. Die erfindungsgemäßen Laminate eignen sich speziell auch für die Abschirmung von Navigations- und Kommunikationseinrichtungen, wie speziell GPS-Systemen, vor elektromagnetischen Strahlen.

### FIGURENBESCHREIBUNG

Figur 1:
   Die Abbildungen a) bis e) zeigen Beispiele für Muster, wie sie die erfindungsgemäßen Laminate als Einschnitte aufweisen können.
Figur 2:

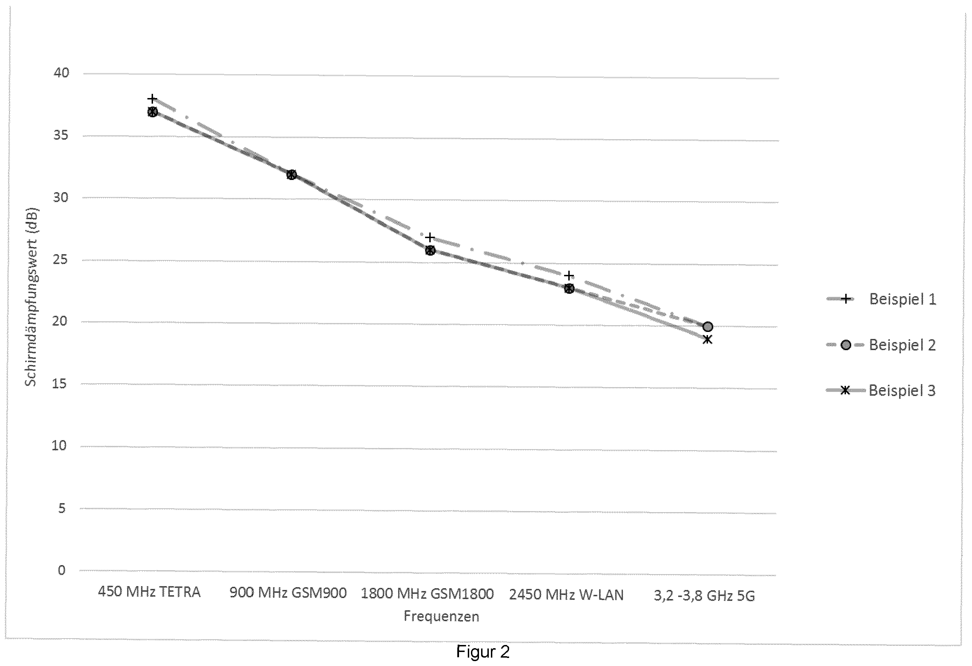

   Figur 2 zeigt die Schirmdämpfung nach ASTM D 4935-2010 in [dB] für die erfindungsgemäßen Laminate der Beispiele 1 bis 3.
Figur 3:

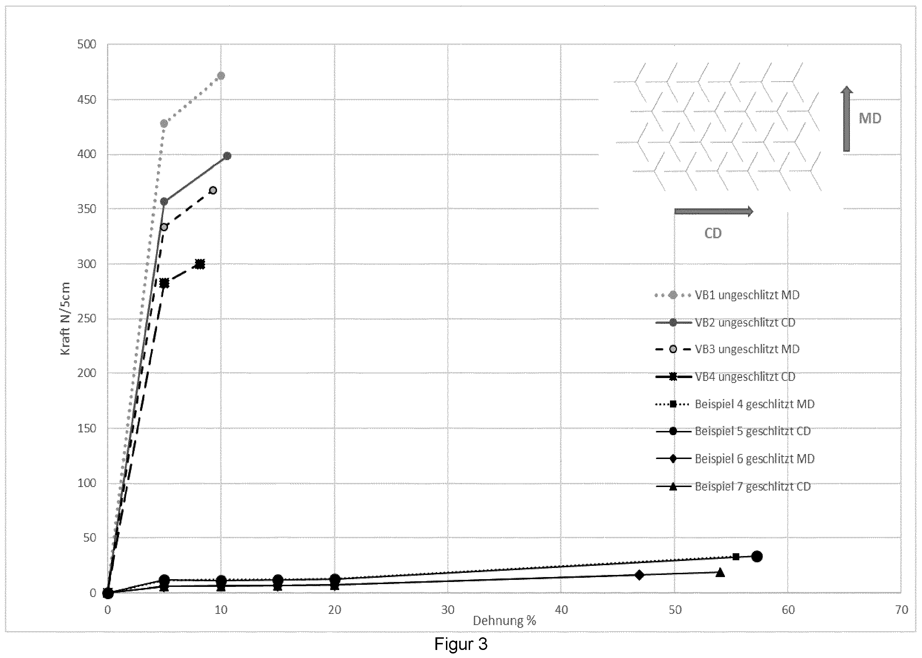

   Figur 3 zeigt die Messwerte des Zugkraft-/Dehnungsverhaltens nach DIN ISO 9073-3:1989-07 an erfindungsgemäßen Laminaten mit Einschnitten und Vergleichslaminaten ohne Einschnitte jeweils in Rollenrichtung (MD) und in Gegenrollenrichtung (CD).

Die Erfindung wird anhand der folgenden, nicht einschränkenden Beispiele näher erläutert.

### BEISPIELE

### Beispiele 1 bis 3:

Zur Herstellung erfindungsgemäßer Laminate wurde ein thermisch verfestigtes Polyester-Spinnvlies auf Basis von PET mit einem Flächengewicht gemäß Tabelle 1 und eine Aluminiumfolie mit einer Dicke gemäß Tabelle 1 eingesetzt. In Beispiel 1 enthält das Substrat zusätzlich eine netzförmige Polyester-Verstärkungseinlage (scrim) auf Basis von PET mit einem Flächengewicht von 5 g/m².

Zur Herstellung von erfindungsgemäßen Laminaten wurde auf die Aluminiumfolie durch Dreifachextrusion mit einer Breitschlitzdüse eine dreilagige Polymerbeschichtung aufgebracht, die aus einer Schicht eines Haftvermittlerpolymers, gefolgt von einer Polyamidschicht (PA 6) und einer zweiten Schicht eines Haftvermittlerpolymers, bestand. Die Temperatur am Austritt der Extruder betrug 295 °C. Das Fasermaterial wurde der heißen Polymerschicht zugeführt und anschließend in einem Kalander aus zwei Walzen bei erhöhter Temperatur und einem Liniendruck von etwa 30 N/mm verpresst.

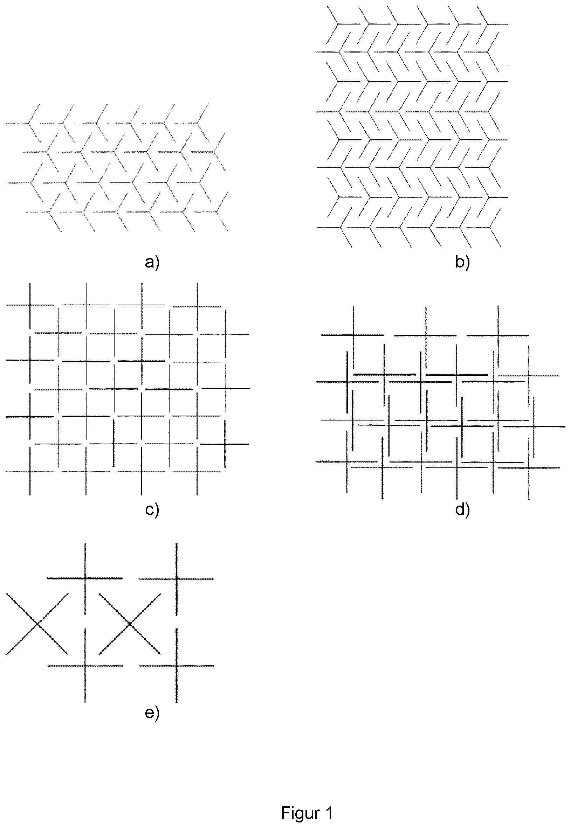

Mithilfe eines Stanzwerkzeugs wurden die Laminate mit einem Muster von Einschnitten versehen, wie es in Abbildung 1a) gezeigt ist. Alle Objekte bestehen aus drei Einschnitten, wobei zwei benachbarte Einschnitte jeweils einen Winkel von 120° einschließen. Die Schnittlänge beträgt 5 mm. Alle Objekte sind gleich orientiert, und der Abstand der Mittelpunkte zweier benachbarter Objekte beträgt 7,5 mm.

**Tabelle 1**

| Beispiel Nr. | Dicke Aluminiumfolie | Substrat |
|---|---|---|
| 1 | 7 µm | PES-Spinnvlies 50 g/m² |
| | | PES-Scrim 5g/m² |
| 2 | 50 µm | PES-Spinnvlies 85 g/m² |
| | | (LDFDH 51085_69, Fa. Freudenberg) |
| 3 | 100 µm | PES-Spinnvlies 85 g/m² |

An den Laminaten der Beispiele 1 bis 3 wurden die Schirmdämpfungswerte nach ASTM D-4935-2010 bestimmt. Wie der Abbildung 2 zu entnehmen ist, wiesen alle Laminate trotz der Einschnitte gute Abschirmungswerte auf.

Beispiele 4 bis 7, Vergleichsbeispiele VB 1 bis 4:
Zur Herstellung erfindungsgemäßer Laminate A) und B) wurde ein thermisch verfestigtes Polyester-Spinnvlies auf Basis von PET (LDFDH 30010_49, Fa. Freudenberg) eingesetzt, mittels Extrusion, wie in den Beispielen 1 bis 3 beschrieben, eine dreilagige Polymerbeschichtung aufgebracht und Aluminiumfolie und Substrat mittels einer Prägewalze punktuell verschweißt.

**Tabelle 2**

| Laminat | Dicke Aluminiumfolie | Substrat |
|---|---|---|
| A | 50 µm | Spinnvlies 100 g/m² |
| | | PA 6 40 g/m² |
| B | 50 µm | Spinnvlies 100 g/m² |
| | | PA 6 40 g/m² |

Durch Laserschneiden mit einem UV-Laser wurden die Laminate A) und B) mit einem Muster von Einschnitten versehen, wie es in den Beispielen 1 bis 3 definiert und in Abbildung 1a) gezeigt ist. Als Vergleichsmaterial dienten Laminate A) und B) ohne Einschnitte.

Aus den erfindungsgemäßen Laminaten und den Vergleichslaminaten wurden jeweils Prüfkörper gestanzt und die Höchstzugkraft (HZK) und Höchstzugdehnung nach DIN ISO 9073-3 bestimmt. Die Messung des Zugkraft-/Dehnungsverhaltens erfolgte jeweils in Rollenrichtung (MD) und in Gegenrollenrichtung (CD). Die Ergebnisse sind in Tabelle 3 und in Abbildung 3 wiedergegeben.

**Tabelle 3**

| Beispiel Nr. | Laminat | HZK [N] | HZD [%] |
|---|---|---|---|
| VB 1 | A (ungeschlitzt, MD) | 471,14 | 10,24 |
| VB 2 | A (ungeschlitzt, CD) | 398,24 | 10,56 |
| VB 3 | B (ungeschlitzt, MD) | 367,2 | 9,31 |
| VB 4 | B (ungeschlitzt, CD) | 300,25 | 8,16 |
| 4 | A (geschlitzt, MD) | 33,13 | 55,42 |
| 5 | A (geschlitzt, CD) | 33,74 | 57,24 |
| 6 | B (geschlitzt, MD) | 16,20 | 46,87 |
| 7 | B (geschlitzt, CD) | 19,04 | 54,01 |

Es zeigt sich, dass die erfindungsgemäßen Laminate signifikant niedrigere Werte bei der Höchstzugkraft und signifikant höhere Werte bei der Längendehnung bis zum Erreichen der Höchstzugkraftdehnung aufweisen. Dies gilt sowohl für die Rollenrichtung als auch die Gegenrollenrichtung. Die erfindungsgemäßen Laminate verfügen somit über eine hohe Dehnbarkeit bei geringem Kraftaufwand in mehr als einer Raumrichtung. Verbunden mit ihrem guten elektromagnetischen Abschirmvermögen eignen sie sich vorteilhaft zur Herstellung abgeschirmter Bauteile auch mit einer komplexen Form.

## Patentansprüche

1. Flexibles Laminat zur Abschirmung elektromagnetischer Strahlung, umfassend
a) wenigstens eine Metallfolie, und
b) ein flächiges Substrat, umfassend oder bestehend aus einem Faser-, Folien- oder Schaummaterial,
wobei das Laminat eine Vielzahl von aus Einschnitten in die Grundfläche des Laminats gebildeten Objekten aufweist, wobei jedes Objekt aus zwei oder mehreren Einschnitten besteht, die einen gemeinsamen Anfangspunkt aufweisen, und wobei die zwei Einschnitte oder je zwei benachbarte Einschnitte einen Winkel von 45 bis 160° aufweisen, wobei das flexible Laminat **dadurch gekennzeichnet ist, dass** die Einschnitte die Metallfolie und das flächige Substrat jeweils vollständig durchtrennen.

2. Laminat nach Anspruch 1, wobei jedes Objekt aus zwei oder mehreren geradlinigen Einschnitten besteht.

3. Laminat nach einem der vorhergehenden Ansprüche, wobei ein Objekt aus je 2, 3, 4, 5 oder 6, bevorzugt 2, 3 oder 4, Einschnitten gebildet wird.

4. Laminat nach einem der vorhergehenden Ansprüche, wobei ein Objekt aus x Einschnitten gebildet wird, wobei x für 3, 4, 5 oder 6 steht und je zwei benachbarte Einschnitte einen Winkel von (360/x)° +/- 20°, bevorzugt einen Winkel von (360/x)° +/- 10°, aufweisen.

5. Laminat nach einem der vorhergehenden Ansprüche, wobei alle Objekte eine Symmetrie aufweisen, ausgewählt unter:
- einer wenigstens 3-zähligen Rotationssymmetrie,
- einer Achsensymmetrie mit wenigstens zwei Spiegelsymmetrieachsen,
- einem Inversionszentrum,
- einer mindestens 3-zähligen Drehspiegelachse.

6. Laminat nach einem der vorhergehenden Ansprüche, wobei die Objekte Gruppen bilden, wobei
- alle Objekte einer Gruppe identische Form, Größe und räumliche Anordnung aufweisen, und
- die gemeinsamen Anfangspunkte aller Objekte einer Gruppe auf einer Geraden liegen.

7. Laminat nach Anspruch 6, wobei die Gruppen ein Muster bilden, wobei
- ein Muster 1, 2, 3, 4, oder mehr als 4 Gruppen von Objekten umfasst,
- alle Geraden, auf denen die Objekte liegen, parallel angeordnet sind,
- die Gruppen in orthogonaler Richtung zu den Geraden eine regelmäßige Abfolge aufweisen.

8. Laminat nach einem der vorhergehenden Ansprüche, wobei die Metallfolie Aluminium umfasst oder aus Aluminium besteht.

9. Laminat nach einem der vorhergehenden Ansprüche, wobei das Substrat b) ein ein- oder mehrlagiges Fasermaterial umfasst, das vorzugsweise ausgewählt ist unter Vliesstoffen, Papieren, Geweben und Kombinationen davon, besonders bevorzugt ausgewählt unter ein- oder zweilagigen Vliesstoffen.

10. Verfahren zur Herstellung eines gegenüber elektromagnetischer Strahlung abgeschirmten Bauteils, bei dem man:
i.1) ein Laminat, wie in einem der Ansprüche 1 bis 9 definiert, und wenigstens ein Polymermaterial (c) oder eine Vorstufe davon bereitstellt,
ii.1) das Laminat und das Polymermaterial (c) oder dessen Vorstufe einer Formgebung unter Verbindung der Materialen unterzieht, und dabei, falls vorhanden, die Vorstufe zur Polymerisation bringt,
oder
i.2) ein Laminat, wie in einem der Ansprüche 1 bis 10 definiert, und wenigstens ein Bauteil bereitstellt,
ii.2) das Bauteil teilweise oder vollständig mit dem Laminat beschichtet oder ummantelt.

11. Verfahren nach Anspruch 10, wobei die Polymerkomponente des Polymermaterials (c) ausgewählt ist unter Polyurethanen, Silikonen, Fluorsilikonen, Polycarbonaten, Ethylen-Vinylacetaten, Acrylnitril-Butadien-Acrylaten, Acrylnitril-Butadien-Kautschuken, Acrylnitril-Butadien-Styrolen, Acrylnitril-Methylmethacrylaten, Acrylnitril-Styrol-Acrylaten, Celluloseacetaten, Celluloseacetatbutyraten, Polysulfonen, Poly(meth)acrylaten, Polyvinylchloriden, Polyphenylenethern, Polystyrolen, Polyamiden, Polyolefinen, Polyketonen, Polyetherketonen, Polyimiden, Polyetherimiden, Polyethylenterephthalaten, Polybutylenterephthalaten, Fluorpolymeren, Polyestern, Polyacetalen, Flüssigkristallpolymeren, Polyethersulfonen, Epoxidharzen, Phenolharzen, Chlorsulfonaten, Polybutadienen, Polybutylen, Polyneoprenen, Polynitrilen, Polyisoprenen, Naturkautschuken, Styrol-Isopren-Styrolen, Styrol-Butadien-Styrolen, Ethylen-Propylenen, Ethylen-Propylen-Dien-Kautschuken, Styrol-Butadien-Kautschuken sowie deren Copolymeren und Mischungen davon.

12. Verfahren nach einem der Ansprüche 10 oder 11, wobei in Schritt i.1) das Polymermaterial (c) in Form eines Verbundwerkstoffs bereitgestellt wird, der die Polymerkomponente des Polymermaterials (c) und wenigstens eine weitere Komponente (K) umfasst, die vorzugsweise ausgewählt ist unter Polymeren, polymeren Werkstoffen, textilen Werkstoffen, keramischen Werkstoffen, mineralischen Werkstoffen und Kombinationen davon, besonders bevorzugt ausgewählt unter verstärkten und/oder gefüllten Kunststoffmaterialien, Polymerfolien, Polymerformkörpern und Kombinationen davon,
bevorzugt in Schritt i.1) das Polymermaterial (c) in Form eines Verbundwerkstoffs bereitgestellt wird, das wenigstens einen faserförmigen Verstärkungsstoff umfasst, wobei die Fasern vorzugsweise ausgewählt sind unter Glasfasern, Kohlenstofffasern, Aramidfasern, Polyesterfasern und Kombinationen davon,
besonders bevorzugt das Polymermaterial (c) in Form eines Verbundwerkstoffs bereitgestellt wird, der einen faserförmigen Verstärkungsstoff umfasst, der in eine thermoplastische Kunststoffmatrix eingebettet ist.

13. Elektromagnetisch abgeschirmtes Bauteil, umfassend wenigstens ein Laminat, wie in einem der Ansprüche 1 bis 9 definiert, oder erhältlich durch ein Verfahren, wie in einem der Ansprüche 10 bis 12 definiert.

14. Verwendung des Laminats, wie in einem der Ansprüche 1 bis 9 definiert, zur Abschirmung elektromagnetischer Strahlen, bevorzugt von stromführenden Systemen und Stromspeichern, besonders bevorzugt in elektronischen Gehäusen, insbesondere in Elektrofahrzeugen, Luftfahrzeugen, Raumfahrzeugen und Drohnen, insbesondere zur Abschirmung elektromagnetischer Strahlen im Bereich der Leistungselektronik, der Batterie, des E-Motors und zur Abschirmung von Navigations- und Kommunikationseinrichtungen, besonders bevorzugt zur Abschirmung elektromagnetischer Strahlen von Invertern, DC/DC-Wandlern, Onboard-Ladegeräten und zur Abschirmung von GPS-Systemen.

## Claims

1. Flexible laminate for shielding from electromagnetic radiation, comprising
a) at least one metal foil, and
b) a sheetlike substrate comprising or consisting of a fibre material, film material or foam material,
wherein the laminate has a multitude of objects formed from incisions into the main area of the laminate, wherein each object consists of two or more incisions having a common starting point, and wherein the two incisions or every two adjacent incisions have an angle of 45 to 160°, wherein the flexible laminate is **characterized in that** the incisions completely sever the metal foil and the sheetlike substrate in each case.

2. Laminate according to Claim 1, wherein each object consists of two or more linear incisions.

3. Laminate according to either of the preceding claims, wherein each object is formed from 2, 3, 4, 5 or 6, preferably 2, 3 or 4, incisions.

4. Laminate according to any of the preceding claims, wherein an object is formed from x incisions where x is 3, 4, 5 or 6, and every two adjacent incisions have an angle of (360/x)° ± 20°, preferably an angle of (360/x)° ± 10°.

5. Laminate according to any of the preceding claims, wherein all objects have a symmetry selected from:
- an at least 3-fold rotational symmetry,
- an axial symmetry having at least two mirror symmetry axes,
- an inversion centre,
- an at least 3-fold rotary reflection axis.

6. Laminate according to any of the preceding claims, wherein the objects form groups wherein
- all objects in a group have the same shape, size and spatial arrangement, and
- the common starting points of all objects in a group are in a straight line.

7. Laminate according to Claim 6, wherein the groups form a pattern wherein
- a pattern comprises 1, 2, 3, 4 or more than 4 groups of objects,
- all straight lines on which the objects lie are in a parallel arrangement,
- the groups have a regular sequence in orthogonal direction to the straight lines.

8. Laminate according to any of the preceding claims, wherein the metal foil comprises aluminium or consists of aluminium.

9. Laminate according to any of the preceding claims, wherein substrate b) comprises a single- or multiply fibre material preferably selected from nonwovens, papers, weaves and combinations thereof, more preferably selected from one- or two-ply nonwovens.

10. Method of producing a component shielded from electromagnetic radiation, in which:
i.1) a laminate as defined in any of Claims 1 to 9 and at least one polymer material (c) or a precursor thereof are provided,
ii.1) the laminate and the polymer material (c) or the precursor thereof are subjected to shaping with bonding of the materials, and this causes the precursor, if present, to polymerize,
or
i.2) a laminate as defined in any of Claims 1 to 10 and at least one component are provided,
ii.2) the component is partly or fully coated or ensheathed with the laminate.

11. Method according to Claim 10, wherein the polymer component of the polymer material (c) is selected from polyurethanes, silicones, fluorosilicones, polycarbonates, ethylene-vinyl acetates, acrylonitrile-butadiene-acrylates, acrylonitrile-butadiene rubbers, acrylonitrile-butadiene-styrenes, acrylonitrile-methyl methacrylates, acrylonitrile-styrene-acrylates, cellulose acetates, cellulose acetate butyrates, polysulfones, poly(meth)acrylates, polyvinylchlorides, polyphenylene ethers, polystyrenes, polyamides, polyolefins, polyketones, polyetherketones, polyimides, polyetherimides, polyethylene terephthalates, polybutylene terephthalates, fluoropolymers, polyesters, polyacetals, liquid-crystal polymers, polyethersulfones, epoxy resins, phenolic resins, chlorosulfonates, polybutadienes, polybutylene, polyneoprenes, polynitriles, polyisoprenes, natural rubbers, styrene-isoprene-styrenes, styrene-butadiene-styrenes, ethylene-propylenes, ethylene-propylene-diene rubbers, styrene-butadiene rubbers and the copolymers and mixtures thereof.

12. Method according to one of Claims 10 or 11, wherein, in step i.1), the polymer material (c) is provided in the form of a composite material comprising the polymer component of the polymer material (c) and at least one further component (K) which is preferably selected from polymers, polymeric materials, textile materials, ceramic materials, mineral materials and combinations thereof, more preferably selected from reinforced and/or filled polymer materials, polymer films, polymer mouldings and combinations thereof,
preferably, in step i.1), the polymer material (c) is provided in the form of a composite material comprising at least one fibrous reinforcing material, where the fibres are preferably selected from glass fibres, carbon fibres, aramid fibres, polyester fibres and combinations thereof,
more preferably, the polymer material (c) is provided in the form of a composite material comprising a fibrous reinforcing material embedded into a thermoplastic polymer matrix.

13. Electromagnetically shielded component comprising at least one laminate as defined in any of Claims 1 to 9, or obtainable by a method according to any of Claims 10 to 12.

14. Use of the laminate as defined in any of Claims 1 to 9 for shielding from electromagnetic rays, preferably from current-conducting systems and power storage means, more preferably in electronic housings, especially electrical vehicles, aircraft, spacecraft and drones, especially for shielding from electromagnetic rays in the field of power electronics, batteries, electric motors, and for shielding of navigation and communication devices, more preferably for shielding from electromagnetic rays from inverters, DC/DC converters, onboard charging devices, and for shielding of GPS systems.

## Revendications

1. Stratifié souple pour une protection contre un rayonnement électromagnétique, comprenant
a) au moins une feuille métallique, et
b) un substrat plan, comprenant, ou en étant constitué, un matériau en fibres, en feuille ou en mousse,
le stratifié comprenant un grand nombre d'objets formés à partir d'entailles dans la surface de base du stratifié, chaque objet étant constitué de deux entailles ou plus, qui ont un point de départ commun, les deux entailles, ou chaque groupe de deux entailles, formant un angle de 45 à 160°, le stratifié souple étant **caractérisé en ce que** les entailles sectionnent complètement tant la feuille métallique que le substrat plan.

2. Stratifié selon la revendication 1, dans lequel chaque objet est constitué de deux entailles rectilignes, ou plus.

3. Stratifié selon l'une quelconque des revendications précédentes, dans lequel chaque objet est formé de 2, 3, 4, 5 ou 6, de préférence 2, 3 ou 4 entailles.

4. Stratifié selon l'une quelconque des revendications précédentes, dans lequel un objet est formé à partir de x entailles, x représentant 3, 4, 5 ou 6, et chaque groupe de deux entailles voisines formant un angle de (360/x)° +/- 20°, de préférence un angle de (360/x)° +/- 10°.

5. Stratifié selon l'une quelconque des revendications précédentes, dans lequel tous les objets présentent une symétrie, choisie parmi :
- une symétrie de rotation d'ordre au moins 3,
- une symétrie axiale comportant au moins deux axes de symétrie spéculaire,
- un centre d'inversion,
- un axe de rotation spéculaire d'ordre au moins 3.

6. Stratifié selon l'une des revendications précédentes, dans lequel les objets forment des groupes,
- tous les objets d'un groupe ayant une forme, une taille et une disposition spatiale identiques, et
- les points de départ communs de tous les objets d'un groupe se trouvant sur une droite.

7. Stratifié selon la revendication 6, dans lequel les groupes forment un modèle,
- un modèle comprenant 1, 2, 3, 4 ou plus de 4 groupes d'objets,
- toutes les droites sur lesquelles se trouvant les objets, sont parallèles,
- les groupes présentant, dans la direction orthogonale par rapport aux droites, une succession régulière.

8. Stratifié selon l'une ou plusieurs des revendications précédentes, dans lequel la feuille métallique comprend de l'aluminium ou est constituée d'aluminium.

9. Stratifié selon l'une quelconque des revendications précédentes, dans lequel le substrat b) comprend un matériau fibreux mono- ou multicouche, qui de préférence est choisi parmi les non-tissés, les papiers, les tissus et les combinaisons de ceux-ci, choisi d'une manière particulièrement préférée parmi les non-tissés mono- ou bicouches.

10. Procédé de fabrication d'un composant protégé d'un rayonnement électromagnétique, dans lequel
i.1) on fournit un stratifié, tel que défini dans l'une quelconque des revendications 1 à 9, et au moins un matériau polymère (c) ou un précurseur de celui-ci,
ii.1) on soumet le stratifié et le matériau polymère (c) ou le précurseur de celui-ci à un façonnage, par assemblage des matériaux, le précurseur, s'il est présent, étant alors porté à polymérisation,
ou
i.2) on fournit un stratifié tel que défini dans l'une quelconque des revendications 1 à 10 et au moins un composant,
ii.2) on revêt ou enveloppe en totalité ou en partie le composant avec le stratifié.

11. Procédé selon la revendication 10, dans lequel le composant polymère du matériau polymère (c) est choisi parmi les matériaux suivants : polyuréthanes, silicones, fluorosilicones, polycarbonates, éthylène-acétates de vinyle, acrylonitrile-butadiène-acrylates, caoutchoucs acrylonitrile-butadiène, acrylonitrile-butadiène-styrènes, acrylonitrile-méthacrylates de méthyle, acrylonitrile-styrène-acrylates, acétates de cellulose, acétobutyrates de cellulose, polysulfones, poly(méth)acrylates, poly(chlorures de vinyle), poly(phénylène éthers), polystyrènes, polyamides, polyoléfines, polycétones, polyéthercétones, polyimides, polyétherimides, poly(téréphtalates d'éthylène), poly(téréphtalates de butylène), polymères fluorés, polyesters, polyacétals, polymères cristaux liquides, polyéthersulfones, résines époxydes, résines phénoliques, chlorosulfonates, polybutadiènes, polybutylène, polynéopropènes, polynitriles, polyisoprènes, caoutchoucs naturels, styrène-isoprène-styrènes, styrène-butadiène-styrènes, éthylène-propylènes, caoutchoucs éthylène-propylène-diène, caoutchoucs styrène-butadiène, ainsi que les copolymères et mélanges de ceux-ci.

12. Procédé selon l'une quelconque des revendications 10 ou 11, dans lequel dans l'étape i.1) le matériau polymère (c) est fourni sous forme d'un matériau composite, qui comprend le composant polymère du matériau polymère (c) et au moins un autre composant (K), qui de préférence est choisi parmi les polymères, les matériaux polymères, les matériaux textiles, les matériaux céramiques, les matériaux minéraux et les combinaisons de ceux-ci, d'une manière particulièrement préférée choisi parmi les matériaux plastiques renforcés et/ou chargés, les feuilles polymères, les objets moulés polymères et les combinaisons de ceux-ci, de préférence, dans l'étape i.1), le matériau polymère (c) est fourni sous forme d'un matériau composite, qui comprend au moins un agent de renfort fibreux, les fibres étant choisies de préférence parmi les fibres de verre, les fibres de carbone, les fibres aramides, les fibres de polyester et les combinaisons de celles-ci, d'une manière particulièrement préférée, le matériau polymère (c) est fourni sous forme d'un matériau composite qui comprend un agent de renfort fibreux, qui est incorporé dans une matrice plastique thermoplastique.

13. Composant protégé contre un rayonnement électromagnétique, comprenant au moins un stratifié tel que défini dans l'une quelconque des revendications 1 à 9 ou pouvant être obtenu par un procédé tel que défini dans l'une quelconque des revendications 10 à 12.

14. Utilisation du stratifié tel que défini dans l'une quelconque des revendications 1 à 9, pour une protection contre des rayonnements électromagnétiques, de préférence de systèmes conducteurs de courant et d'accumulateurs de courant, d'une manière particulièrement préférée dans des boîtiers électroniques, en particulier dans les véhicules électriques, les véhicules aériens, les véhicules spatiaux et les drones, en particulier pour une protection contre les rayonnements électromagnétiques dans le domaine de l'électronique de puissance, de la batterie du moteur électrique, ou pour une protection des dispositifs de navigation et de communication, d'une manière particulièrement préférée pour protéger des rayonnements électromagnétiques d'inverseurs, de convertisseurs CC/CC, de chargeurs à bord, et pour la protection de systèmes GPS.
